# EUROPEAN PATENT APPLICATION

(11) **EP 4 114 162 A1**
(43) Date of publication of application: **04.01.2023**
(21) Application number: 22179219.5
(22) Date of filing: 15.06.2022
(51) Int. Cl.: H05K 7/20

(54) **A POWER CONVERTOR AND AN ELECTRIC VEHICLE COMPRISING THE POWER CONVERTOR**

(30) Priority: 17.06.2021 CN 202121351153 U
(71) Applicant: Valeo Siemens Eautomotive (Shenzhen) Co., Ltd., Fuyong Sub-district, Bao'an District Shenzhen 518128 (CN)
(72) Inventor: ZHANG, Xiping, Shenzhen 518128 (CN); GUAN, Xing, Shenzhen 518128 (CN)
(74) Representative: Novembre, Christophe Adelphe

(57) **Abstract**

The present disclosure relates to a power convertor and an electric vehicle comprising the power convertor. The power convertor comprises a casing (1), a printed circuit board (2), a radiator (3) having mounting holes (6), an insulator (4) at least partially disposed between the printed circuit board (2) and the radiator (3), and fasteners (5) disposed in the mounting holes (6) to fix the radiator (3) to the casing (1), wherein the insulator (4) comprises guide portions (7), the guide portions (7) each have a guide passage (71) allowing a fastener (5) to pass through, and the guide passages are aligned with the mounting holes (6) and extend from the insulator (4) towards the mounting holes (6).

## Description

### Technical Field

The present disclosure relates to a power convertor and an electric vehicle comprising the power convertor.

### Background of the invention

With the advancement of energy-saving and emission reduction plans and the demand on atmospheric pollution control in China, the electric vehicle (EV) market has grown rapidly and EVs will be the main product in the future automobile market. An on-board charger (OBC), a DC-DC convertor and a high-voltage power distribution unit (PDU) are important constituents of an EV. The DC-DC convertor converts a DC power supply voltage to any DC voltage to provide the required power for the power steering system, the air conditioner in the EV and other auxiliary equipment. The high-voltage PDU is connected to the power battery, the motor controller and the frequency convertor of the EV to provide the high-voltage system of the EV with the functions, such as charging and discharging control, power-on control of high-voltage components, circuit overload and short-circuit protection, high-voltage sampling and low-voltage control to protect and monitor the running of the high-voltage system.

Separately packaged OBCs, DC-DC convertors and high-voltage PDUs are used in some known EVs. The assembly of these products is decentralized and complex, the cost is increased, a large space is occupied, and it is difficult to route communication cables between devices. Therefore, such an assembly mode is not suitable for EVs with little space but a lot of components. In addition, with the increase of the functions configured for a whole EV and the increase of the required power, the problems that the volume of parts is increased, cable routing is complex and assembly is difficult have gradually emerged. For this reason, more and more attention is paid to the integration design of parts.

With the continuous progress of technologies, the OBC, the DC-DC convertor and the high-voltage PDU have been integrated to form a three-in-one product in other EVs. Such a product can not only reduce the occupied space, but also save the cost in cable routing.

However, with the increase of the required power, the assembly of the above-mentioned product has become more and more difficult. How to realize effective heat dissipation in an integrated product and how to provide a product which is convenient to assemble, disassemble and maintain have become the technical problems which need to be urgently solved in the art.

### Summary of the invention

The object of the present disclosure is to provide a power convertor and an electric vehicle comprising the power convertor. The power convertor is convenient to assemble, disassemble and maintain, the occupied space is small, and the cost is low. In addition, the power convertor can realize effective heat dissipation in an integrated product.

The above-mentioned object is achieved through the power convertor described below and an EV comprising the power convertor.

The present disclosure relates to a power convertor, and the power convertor comprises: a casing, a printed circuit board, a radiator having mounting holes, an insulator at least partially disposed between the printed circuit board and the radiator, and fasteners disposed in the mounting holes to fix the radiator to the casing. The insulator comprises guide portions, the guide portions each have a guide passage allowing a fastener to pass through, and the guide passages are aligned with the mounting holes and extend from the insulator towards the mounting holes.

In some embodiments, the guide portions comprise a plurality of petal portions extending from the body of the insulator, and the guide passages are formed by the plurality of petal portions.

In some embodiments, the plurality of petal portions form the guide passages which are progressively reduced towards the mounting holes.

In some embodiments, the free ends of the petal portions are located above the level of the top surfaces of the fasteners.

In some embodiments, the free ends of the petal portions are located below the level of the top surfaces of the fasteners.

In some embodiments, the petal portions press against the parts of the fasteners above the mounting holes.

In some embodiments, the fasteners are screws.

In some embodiments, the diameter of the parts of the guide passages near to the printed circuit board is greater than the head diameter of the screws, and the diameter of the parts of the guide passages near to the mounting holes is greater than the thread diameter of the screws but less than the head diameter of the screws.

In some embodiments, the petal portions are made of a deformable material.

In some embodiments, the guide portions are integrated with the insulator.

In some embodiments, no thread is provided on the inner walls of the mounting holes.

In some embodiments, the guide portions are located at the corners of the insulator.

In some embodiments, the power convertor is a DC-AC convertor, DC-DC convertor or an AC-DC convertor.

The present disclosure further relates to an EV and the EV comprises the power convertor described above.

### Brief Description of the Drawings

The advantages and object of the present disclosure can be better understood from the preferred implementation mode of the present disclosure described in detail in combination with the drawings. In order to better show the relationships between components in the drawings, the drawings are not drawn to scale. In the drawings,
Fig. 1 is a partial view of the power convertor according to one embodiment of the present disclosure, wherein the inside of the guide portions is shown,
Fig. 2 is an exploded partial view of the power convertor according to one embodiment of the present disclosure,
Fig. 3 is a schematic view of the insulator of the power convertor according to one embodiment of the present disclosure,
Fig. 4 is a schematic cutaway view of the height of the guide passage of a guide portion of the insulator of the power convertor according to one embodiment of the present disclosure,
Fig. 5 is a partial view of the power convertor according to one embodiment of the present disclosure, wherein a guide portion of the insulator is shown, and
Fig. 6 is a partial view of the power convertor according to a further embodiment of the present disclosure, wherein a guide portion of the insulator is shown.

### Detailed Description of the Invention

To make clearer the object, technical solutions and advantages of the present disclosure, the technical solutions of specific embodiments of the present disclosure will be clearly and completely described below in combination with the drawings of the embodiments of the present disclosure. The same reference numeral in the drawings represents the same component. It should be noted that the embodiments described are a part, but not all, of the embodiments of the present disclosure. All other embodiments obtained by those skilled in the art on the basis of the described embodiments of the present disclosure without any creative work should fall within the scope of protection of the present disclosure.

Unless otherwise defined, the technical terms or scientific terms used here should have ordinary meanings that those skilled in the art understand. "First", "second" and similar terms used in the description and the claims of the patent application of the present disclosure are not used to represent any specific sequence, quantity or importance, but are only used to distinguish between different constituents. Similarly, "a" or "one" or a similar term does not necessarily represent a quantity restriction. "Comprise", "contain" or "have" or a similar term means that an element or article coming before the term covers the enumerated elements or articles or equivalents coming after the term, but does not exclude other elements or articles. "Joining" or "connection" or a similar term is not limited to a physical or mechanical joining or connection shown in the drawings, but includes an equivalent joining or connection, directly or indirectly. The terms "above", "below", "left" and "right" are only used to represent relative position relationships, and a relative position relationship is possibly changed accordingly after the absolute position of an object described is changed.

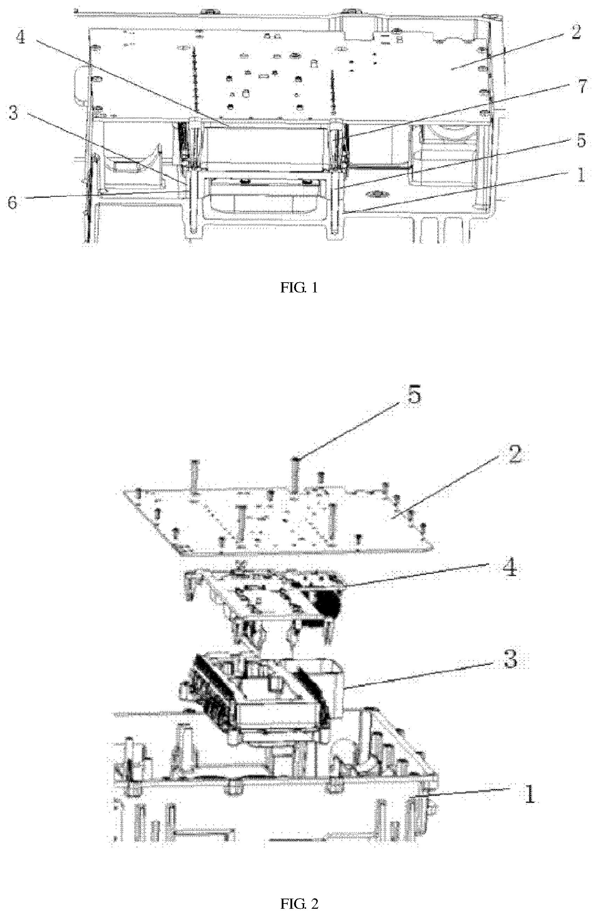

Embodiments of the present disclosure are described in detail below in combination with Fig. 1 to 6.

Fig. 1 shows a power convertor for an EV according to one embodiment of the present disclosure. For example, the power convertor of the present disclosure may be a DC-AC convertor, DC-DC convertor or an AC-DC convertor (for example, an OBC). The power convertor of the present disclosure can be integrated with the PDU. For example, the power convertor of the present disclosure can be integrated to form a three-in-one product consisting of an OBC, a DC-DC convertor and a high-voltage PDU. The power convertor of the present disclosure can be used not only for EVs, but also for hybrid vehicles or other motor vehicles.

As shown in Fig. 1 and 2, the power convertor comprises a casing 1, a printed circuit board 2, a radiator 3 and an insulator 4. The electric components and lines of the power convertor are disposed on the printed circuit board 2 and produce heat, which needs to be dissipated to avoid influencing the service life of the power convertor or damaging the electric components during work. Especially in an integrated product, more electric components and lines are disposed on the printed circuit board 2. Therefore, it is necessary to dissipate heat more efficiently and quickly to avoid influencing a plurality of electric components. To provide a quicker and more efficient heat dissipation effect, the radiator 3 is usually separated from the casing 1 and the radiator 3 is welded to the printed circuit board 2. A passage allowing a cooling fluid to flow through to dissipate heat produced on the printed circuit board 2 is provided in the radiator 3. The insulator 4 is at least partially disposed between the printed circuit board 2 and the radiator 3, for example, sandwiched between the printed circuit board 2 and the radiator 3, to insulate the printed circuit board and the radiator. For example, the insulator 3 is in the form of a plate. For example, one or more bulges facing the printed circuit board 2 is provided on the insulator 3, and recesses corresponding to the bulges are provided on the printed circuit board 2. Through the cooperation between the bulges and the recesses, the insulator 3 is prevented from moving relative to the printed circuit board 2.

Then, the radiator 3 and the printed circuit board 2 which are welded together is disposed on the casing 1. In one embodiment of the present disclosure, the power convertor further comprises fasteners 5 and mounting holes 6 are provided in the radiator 3. The fasteners 5 are disposed in the mounting holes 6 to fix the radiator 3 to the casing 1. For example, the fasteners 5 are screws, and the printed circuit board 2 and the radiator 3 which are welded together can be fixed to the casing 1 with screws. In some implementation modes, the radiator 3 can be removed from the casing 1 by removing the fasteners 5, for example, by screwing off the screws. In some implementation modes, no thread is provided on the inner walls of the mounting holes 6, and the screws pass through the mounting holes 6 and are only tightened into corresponding threaded holes in the casing 1.

As shown in Fig. 2, the printed circuit board 2 is usually much greater than the radiator 3 in size, usually covering the radiator 3 completely. This restricts the layout of the fasteners 5 fixing the radiator 2 to the casing 1. To save space and provide an integration, the fasteners 5 usually need to pass through the printed circuit board 2 and then fix the radiator 3 to the casing 1. In the power convertor of the present disclosure, the distance between the printed circuit board 2 and the casing 1 is too long, that is to say, the distance in the vertical direction in Fig. 1 and 2 is too long, because the volume of the radiator 3 is large, and the fasteners 5 need to go a long distance after passing through the holes in the printed circuit board 5 and then can be screwed in the threaded holes in the casing 1. If the fasteners 5 are not guided by guide portions in the long distance, it will be unfavorable to fix the radiator 3 to the casing, or even worse, the assembly of the radiator and the casing will fail because the fasteners are not properly disposed in the mounting holes 6 in the radiator 3.

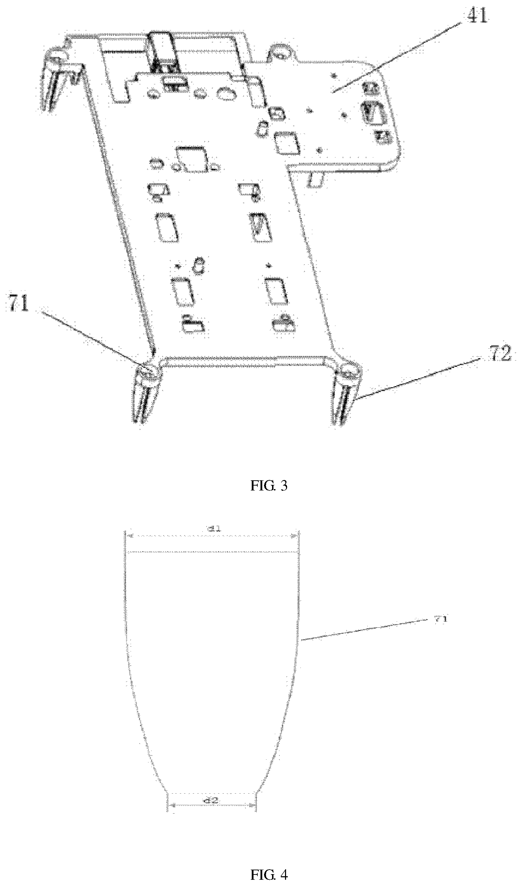

To avoid the above-mentioned case, the insulator 4 of the power convertor of the present disclosure comprises guide portions 7, which are used to guide the fasteners 5 through the distance between the printed circuit board 2 and the casing 1, especially the distance between the printed circuit board 2 and the mounting holes 6 in the radiator 3. As shown in Fig. 3, the guide portions 7 have guide channels 71 allowing the fasteners 5 to pass through. As shown in Fig. 1 and 2, the guide passages 71 are aligned with the mounting holes 6 in the radiator 3 and extend from the insulator 4 towards the mounting holes 6.

For example, the guide portions 7 are integrated with the insulator 4, and are made of the same insulating material as that of the insulator 4. At least one of the guide portions 7 is located at a corner of the insulator 4. For example, as shown in Fig. 3, three guide portions 7 are located at three corners of the insulator 4. In the example shown in Fig. 1 to 3, the number of guide portions 7 is four and they are respectively used to assemble four fasteners 5 used. In other implementation modes, the four guide portions 7 can be located at four corners of the insulator 4. The positions and the number of guide portions are not restricted for the present utility, and the number of guide portions can be configured and the positions of guide portions can be modified according to the design requirements, application situations and other factors of the power convertor.

See Fig. 3 again. The guide portions 7 comprise a plurality of petal portions 72 extending from the body 41 of the insulator 4, and the guide channels 71 are formed by the plurality of petal portions 72. The plurality of petal portions 72 extend roughly perpendicular to the body 41 of the insulator 4. For example, the guide portions 7 comprise two separated petal portions 72. In other implementation modes, the number of petal portions 72 can be different. For example, the petal portions 72 are made of a deformable material.

See the cutaway views of the guide passages 71 on a plane perpendicular to the body 41 of the insulator 4 in Fig. 1 and 4. The plurality of petal portions 72 form guide passages 71 which are progressively reduced towards the mounting holes 6 in the radiator 3. In a natural condition without any influence of other components, the size of the guide passages 71 of the guide portions 7 near to the printed circuit board 2, namely, at the top is d1, and the size of the guide passages 71 of the guide portions 7 near to the mounting holes 6 in the radiator 3, namely, at the bottom is d2, wherein d2 is less than d1. As shown in Fig. 3, the cross-section of the guide passages 71 on a plane parallel to the body of the insulator 4 can be a circle. In this case, the sizes d1 and d2 are the diameter of the top and the diameter of the bottom, respectively. In other implementation modes, the guide passages 71 can have a roughly conical profile.

To allow the screws serving as the fasteners 5 to pass through the guide passages 71 in the guide portions 7 and provide an unblocked guide for the screws, the diameter of the parts of the guide passages 71 near to the printed circuit board 2 (namely, the diameter d1 of the top of the guide passages 71) is greater than the head diameter of the screws, and the diameter of the parts of the guide passages 71 near to the mounting holes 6 (namely, the diameter d2 of the bottom of the guide passages 71) is greater than the thread diameter of the screws but less than the head diameter of the screws.

With such size settings, the petal portions 72 made of a deformable material can be spread out by the screws and press against the screws to exert a stress on the screws so that the screws are kept in positions aligned with the mounting holes 6 when passing through the guide passages 71. Such a setting facilitates the assembly of the radiator and the casing.

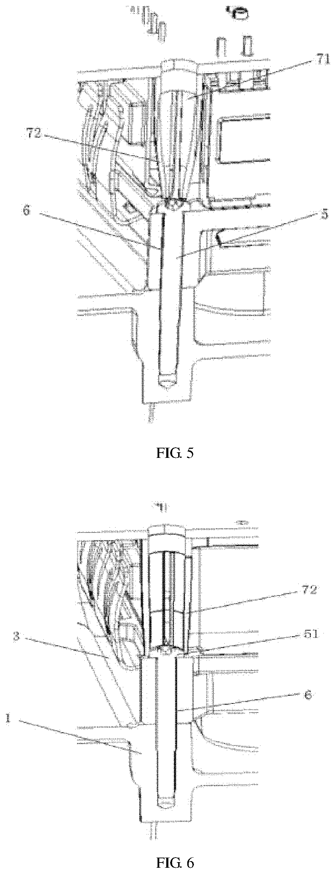

As shown in Fig. 5, in one implementation mode of the present disclosure, after the fasteners 5 fix the radiator 3 to the casing 1, the free ends of the petal portions 72 are located above the level of the top surfaces of the fasteners 5. That is to say, the free ends of the petal portions 72 are a distance away from the top surfaces of the fasteners 5. The free end of the petal portions 72 refers to one end of the petal portions 72 which is away from the body 41 of the insulator 4 and can be deformed under the action of the fasteners. In Fig. 5, the free ends of the petal portions 72 are a distance away from the top surfaces of the screw heads. In such an implementation mode, the screw heads are not located in the guide passage 71 any longer and the diameter d2 of the parts of the guide passages 71 near to the mounting holes 6 is less than the head diameter of the screws. Therefore, when the screws are unscrewed, the free ends of the petal portions 72 will prevent the screws from moving further and the screws cannot be removed from the mounting holes 6. That is to say, the screws are not detachable in such an implementation mode.

As shown in Fig. 6, in one implementation mode of the present disclosure, after the fasteners 5 fix the radiator 3 to the casing 1, the free ends of the petal portions 72 are located below the level of the top surfaces of the fasteners 5. The petal portions 72 press against the parts 51 of the fasteners 5 above the mounting holes 6 to exert a force on the parts 51, for example. In Fig. 6, the parts 51 of the fasteners 5 located above the mounting holes 6, namely, the screw heads, are still located in the guide passages 71. In this case, the petal portions 72 are spread out by the screw heads and are deformed so that the diameter d2 of the bottom of the guide passages 71 is equal to the head diameter of the screws. Since at least a part of the screw heads is still located in the guide passages 71, the screws can be removed from the mounting holes 6 under the guide of the guide passages 71 after the screws are unscrewed. That is to say, the screws are detachable in such an implementation mode. Therefore, the radiator can be removed from the casing for a replacement or maintenance.

The power convertor of the present disclosure is convenient to assemble, disassemble and maintain, the occupied space is small, and the cost is low. Especially, the power convertor of the present disclosure can realize a high power without any necessity of greatly changing the casing and other components, and in addition, effective heat dissipation can be realized in an integrated product.

In addition, the technical features disclosed above are not limited to the combinations of the disclosed features with other features, those skilled in the art can further make other combinations between various technical features according to the object of the present disclosure to realize the object of the present disclosure.

## Claims

1. An power convertor, comprising:
a casing (1),
a printed circuit board (2),
a radiator (3) having a mounting hole (6),
an insulator (4) at least partially disposed between the printed circuit board (2) and the radiator (3), and
fasteners (5) disposed in the mounting holes (6) to fix the radiator (3) to the casing (1),
**characterized in that**
the insulator (4) comprises guide portions (7), the guide portions (7) each have a guide passage (71) allowing a fastener (5) to pass through, and the guide passages are aligned with the mounting holes (6) and extend from the insulator (4) towards the mounting holes (6).

2. The power convertor according to Claim 1, **characterized in that**
the guide portions (7) comprise a plurality of petal portions (72) extending from the body (41) of the insulator (4), and the guide passages (71) are formed by the plurality of petal portions (72).

3. The power convertor according to Claim 2, **characterized in that**
the plurality of petal portions (72) form the guide passages which are progressively reduced towards the mounting holes (6).

4. The power convertor according to Claim 3, **characterized in that**
the free ends of the petal portions (72) are located above the level of the top surfaces of the fasteners (5).

5. The power convertor according to Claim 3, **characterized in that**
the free ends of the petal portions (72) are located below the level of the top surfaces of the fastener (5).

6. The power convertor according to Claim 5, **characterized in that**
the petal portions (72) press against the parts (51) of the fasteners (5) above the mounting holes (6).

7. The power convertor according to any of Claims 2 to 6, **characterized in that**
the fasteners (5) are screws.

8. The power convertor according to Claim 7, **characterized in that**
the diameter of the parts of the guide passages (71) near to the printed circuit board (2) is greater than the head diameter of the screws, and the diameter of the parts of the guide passages (71) near to the mounting holes (6) is greater than the thread diameter of the screws but less than the head diameter of the screws.

9. The power convertor according to any of Claims 2 to 6, **characterized in that**
the petal portions (72) are made of a deformable material.

10. The power convertor according to any of Claims 1 to 6, **characterized in that**
the guide portions (7) are integrated with the insulator (4).

11. The power convertor according to any of Claims 1 to 6, **characterized in that**
no thread is provided on the inner walls of the mounting holes (6).

12. The power convertor according to any of Claims 1 to 6, **characterized in that**
the guide portions (7) are located at the corners of the insulator (4).

13. The power convertor according to any of Claims 1 to 6, **characterized in that**
the power convertor is a DC-AC convertor, DC-DC convertor or AC-DC convertor.

14. An electric vehicle, **characterized in that** the electric vehicle comprises the power convertor according to any of Claims 1 to 13.
